# EUROPEAN PATENT SPECIFICATION

(11) **EP 2 717 328 B1**
(45) Date of publication and mention of the grant of the patent: **07.10.2020**
(21) Application number: 12791968.6
(22) Date of filing: 16.03.2012
(51) Int. Cl.: H01L 31/048

(54) **MANUFACTURING METHOD FOR A SOLAR MODUL**
HERSTELLUNGSVERFAHREN FÜR EIN SOLARZELLENMODUL
PROCÉDÉ DE FABRICATION POUR UN MODULE DE CELLULES SOLAIRES

(30) Priority: 27.05.2011 JP 2011118759
(43) Date of publication of application: 09.04.2014
(73) Proprietor: Panasonic Intellectual Property Management Co., Ltd., Osaka-shi, Osaka 540-6207 (JP)
(72) Inventor: YOSHIMINE, Yukihiro, Moriguchi-shi Osaka 570-8677 (JP)
(74) Representative: Glawe, Delfs, Moll
(86) International application number: PCT/JP2012/056892
(87) International publication number: WO 2012/165003

(56) References cited:
- EP-A1- 2 249 398
- EP-A2- 2 020 688
- WO-A1-2009/044732
- JP-A- 6 334 207
- JP-A- 2002 519 473
- JP-A- 2010 024 416
- JP-A- 2011 054 663
- Pubchem: "Urethane | NH2COOC2H5 - PubChem", , 16 September 2004 (2004-09-16), XP055475077, Retrieved from the Internet: URL:https://pubchem.ncbi.nlm.nih.gov/compo und/urethane [retrieved on 2018-05-15]

## Description

### FIELD OF THE INVENTION

The present invention relates to a manufacturing method for a solar module.

### BACKGROUND OF THE INVENTION

Solar modules have attracted much attention in recent years as an energy source with a low environmental impact. In each of document JP2010225801 A and document EP2020688 A2, the solar module includes a plurality of solar cells arranged inside a sealing member. The solar cells are connected electrically by a wiring member. The wiring member is connected to the solar cells using a resin adhesive.

### SUMMARY OF THE INVENTION

### Problem Solved by the Invention

Because a solar module is installed in a location exposed to sunlight, the temperature of the solar module is often high and the solar module is subjected to thermal stress. A solar module is also subjected to thermal stress during the lamination process in which the solar cells are modularized. Therefore, a solar module which is more reliable with respect to thermal stress is desired.

In view of this situation, it is an object of the present invention to provide a manufacturing method for a highly reliable solar module.

### Means of Solving the Problem

The present invention relates to a manufacturing method for a solar module having a sealing member and a solar cell string arranged inside the sealing member, the solar cell string having a plurality of solar cells, a wiring member connecting the plurality of solar cells electrically, and a resin adhesive bonding the wiring member and the plurality of solar cells. In the manufacturing method for a solar module of the present invention, a first resin sheet for constituting a portion of the sealing member, the solar cell string, and a second resin sheet for constituting another portion of the sealing member are stacked in this order to create multilayers. By laminating multilayers, the sealing member is configured from the first and second resin sheets and a solar module is obtained. The lamination of the multilayers is performed at a temperature less than the glass transition temperature of the resin adhesive by at least 20°C. The melting point of the sealing member is from 60°C to 180°C.

### Effect of the Invention

The present invention is able to provide a highly reliable solar module.

### BRIEF DESCRIPTION OF THE DRAWINGS

FIG. 1 is a schematic plan view of a solar module according to a first embodiment.
FIG. 2 is a schematic cross-sectional view from line II-II in FIG. 1.
FIG. 3 is a schematic cross-sectional view from line III-III in FIG. 1.
FIG. 4 is a schematic cross-sectional view used to explain the manufacturing process for a solar module according to the first embodiment.
FIG. 5 is a schematic cross-sectional view along the x-direction and the z-direction of a solar module according to a second embodiment.

### DETAILED DESCRIPTION OF THE INVENTION

The following is an explanation of examples of preferred embodiments of the present invention. The following embodiments are merely examples. The present invention is not limited to the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### 1st Embodiment

### Configuration of Solar Module 1

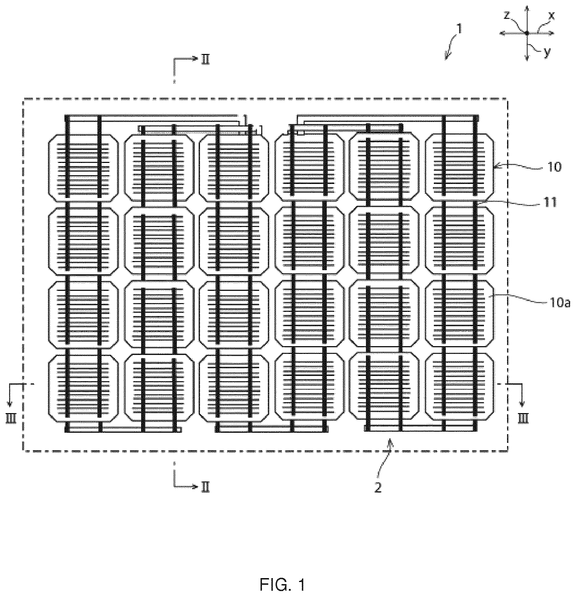

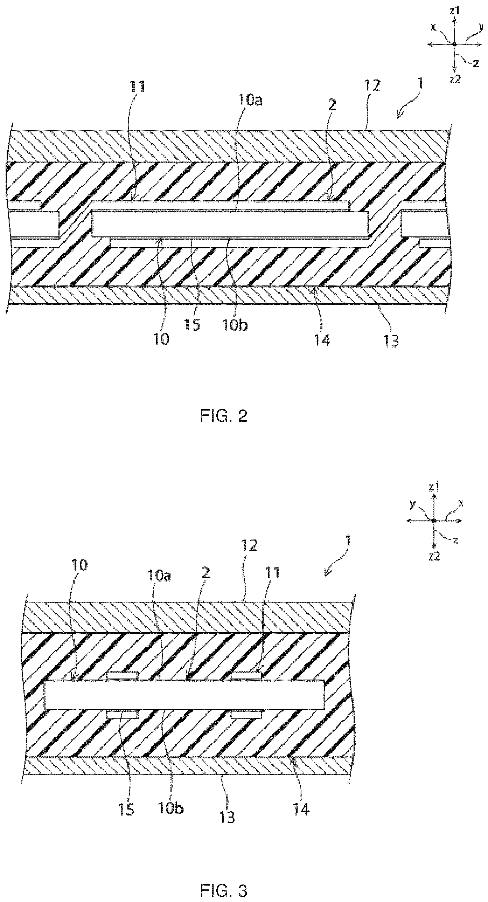

FIG. 1 is a schematic plan view of a solar module according to a first embodiment. FIG. 2 is a schematic cross-sectional view from line II-II in FIG. 1. FIG. 3 is a schematic cross-sectional view from line III-III in FIG. 1.

The solar module 1 includes a plurality of solar cell strings 2. The solar cell strings 2 are arranged at an interval from each other in one direction (the x direction). Solar strings 2 adjacent to each other in the x direction are connected to each other electrically.

Each solar cell string 2 has a plurality of solar cells 10. In each solar cell string 2, the solar cells 10 are connected electrically by a wiring member 11. More specifically, the solar cells 10 are connected electrically in series by electrically connecting one electrode to another in adjacent solar cells 10 using a wiring member 11. In each solar cell string 2, the solar cells 10 are arranged at an interval from each other in another direction (the y direction) perpendicular to the one direction (x direction). Thus, the solar cells 10 in the solar module 1 are arranged at intervals in a matrix in both the x direction and the y direction.

The wiring member 11 can be constituted from a metal such as Cu, Al or Ag, or an alloy such as a Cu alloy, Al alloy or Ag alloy. The wiring member 11 may also be a multilayer of a plurality of conductive members.

The wiring member 11 and solar cells 10 are bonded using a resin adhesive 15. The resin adhesive 15 may comprise a resin that does not contain conductive particles. In this case, the wiring member 11 must come into direct contact with the electrodes of the solar cells 10. The resin adhesive 15 may also contain conductive particles dispersed throughout the resin. In this case, the wiring member 11 and the electrodes of the solar cells 10 may come into direct contact, or may come into contact via the conductive particles.

The conductive particles can be particles of a metal such as Ag, Al, Ni, Au or Cu, or particles of an alloy comprising at least one of these metals. They can also be insulating particles covered with a conductive coating. The insulating particles can be ceramic particles of silica or alumina, or resin particles. The conductive coating can be a metal such as Ag or Al, or an alloy containing at least one of these metals.

In the present invention, the resin may be a resin composition to which an additive such as a filler has been added.

Each solar cell 10 has a light-receiving surface 10a and a back surface 10b (see FIG. 2 and FIG. 3). Here, the main surface on which light is directly incident is the light-receiving surface 10a, and the other main surface is the back surface 10b. However, each solar cell 10 may receive light and generate electricity on both the light-receiving surface 10a and the back surface 10b. In other words, the solar cells 10 may generate no electricity when light is received on the back surface 10b, or may be bifacial light-receiving solar cells.

There are no particular restrictions on the type of solar cells 10. The solar cells 10 can be crystalline silicon solar cells, thin-film silicon solar cells, compound semiconductor solar cells, organic thin-film solar cells, dye-sensitized solar cells, or quantum dot solar cells.

A light-receiving surface protecting member 12 is arranged on the light-receiving surface 10a (z1 side) of the solar cells 10. The light-receiving surface protecting member 12 transmits light in the wavelengths contributing to the generation of electricity in the solar cells 10. The light-receiving surface protecting member 12 can be a glass plate or a plastic plate.

A back surface protecting member 13 is arranged on the back surface 10b (z2 side) of the solar cells 10. It is a member which reflects light in the wavelengths contributing to the generation of electricity in the solar cells 10. The back surface protecting member 13 often has a reflective surface on the solar cell 10 side that reflects light in the wavelengths contributing to the generation of electricity in the solar cells 10. In the case of bifacial light-receiving solar cells, the back surface protecting member 13 transmits light in the wavelengths contributing to the generation of electricity in the solar cells 10.

The back surface protecting member 13 consists of a flexible sheet. The back surface protecting member 13, for example, can be constituted as a member in which a weather-resistant film and a reflective layer are stacked in order from the side opposite that of the solar cell 10. The back surface protecting member 13 can also be constituted, for example, as a member in which a weather-resistant film and a reflective layer are stacked in order from the side opposite that of the solar cell 10. The reflective layer can be made of metal, an alloy or a white resin. An adhesive layer may be provided between the weather-resistant film and the reflective layer, and between the reflective layer and the weather-resistant film. The weather-resistant film, reflective layer and weather-resistant film may have a single-layer structure or a stacked structure.

A sealing member 14 is provided between the light-receiving surface protecting member 12 and the back surface protecting member 13. The sealing member 14 transmits light in the wavelengths contributing to the generation of electricity in the solar cells 10. A plurality of solar cell strings 2 are arranged inside the sealing member 14. The light-receiving surface protecting member 12 is provided on the z1 side of the sealing member 14 (the side with the light-receiving surface 10a) and the back surface protecting member 13 is provided on the z2 side (the side with the back surface 10b) in the z direction, or thickness direction, of the solar cells 10.

In the present embodiment, the entire sealing member 14 comprises resin portions containing a non-crosslinked resin. Preferred examples of non-crosslinked resins that can be used as a constituent material in the sealing member 14 include olefin resins such as polyethylene (PE) and polypropylene (PP), and ionomer resins.

Polyolefin resins are preferably used as a constituent material in the sealing member 14. When the sealing member 14 is made of a polyolefin resin, the polyolefin resin can effectively suppress infiltration of moisture into the sealing member 14, since polyolefin resins have a lower moisture content than ethylene-vinylacetate copolymers (EVA). Also, polyolefin resins provide better electrical insulation than EVA. By configuring the sealing member 14 from a polyolefin resin, the reliability of the solar module 1 can be further increased.

In the solar module 1, the glass transition temperature (Tg) of the resin adhesive 15 is higher than the melting point of the sealing member 14 containing a non-crosslinked resin. The glass transition temperature of the resin adhesive 15 is higher than the melting point of the sealing member 14 preferably by at least 10°C, and more preferably by at least 20°C. More specifically, the melting point of the sealing member 14 is from 60°C to 180°C and more preferably from 60°C to 120°C. The glass transition temperature of the resin adhesive 15 is preferably equal to or greater than 140°C, and more preferably equal to or greater than 150°C. It is preferable to include at least one resin from among epoxy, phenol, acrylic, imide and urethane resins as a resin suitable for obtaining a resin adhesive 15 having such a glass transition temperature.

In the present invention, the glass transition temperature of the resin is measured using thermo mechanical analysis (TMA). The TMA method is used under the following conditions.
Measurement Mode: Tension
Weight: 1 g
Temperature Gradient: 5°C/min.
Sample Shape: Film

Exposure to sunlight often causes the temperature of a solar module to rise and the temperature of the sealing member to exceed the melting point of the sealing member. When the glass transition temperature of the resin adhesive is lower than the melting point of the sealing member, and the temperature of the sealing member exceeds the melting point of the sealing member, the resin adhesive becomes vitreous, the creep rupture phenomenon occurs, and the bonding strength of the resin adhesive deteriorates. As a result, stress on the wiring member and solar cells and stress from thermal expansion of the sealing member causes the wiring member to become displaced.

In the present embodiment, however, the glass transition temperature of the resin adhesive 15 is lower than the melting point of the sealing member 14. Therefore, when the solar module 1 is heated and the temperature of the sealing member 14 exceeds the melting point of the sealing member 14, the resin adhesive 15 becomes vitreous but the creep rupture phenomenon does not occur. As a result, displacement of the wiring member 11 can be more effectively controlled, and a more reliable solar module is obtained.

Lowering the melting point of the sealing member 14 without altering the melting point of the resin adhesive 15 can be thought of as a way to raise the glass transition temperature of the resin adhesive 15 above the melting point of the sealing member 14. However, if the melting point of the sealing member 14 is too low, the viscosity of the sealing member 14 may be too low when the temperature of the solar module 1 rises. However, when the melting point of the sealing member 14 becomes too high while the melting point of the resin adhesive 15 remains unaltered, the time required to perform the lamination process and manufacture a solar module increases. Therefore, the melting point of the sealing member 14 is from 60°C to 180°C, and more preferably from 60°C to 120°C.

### Method of Manufacturing Solar Module 1

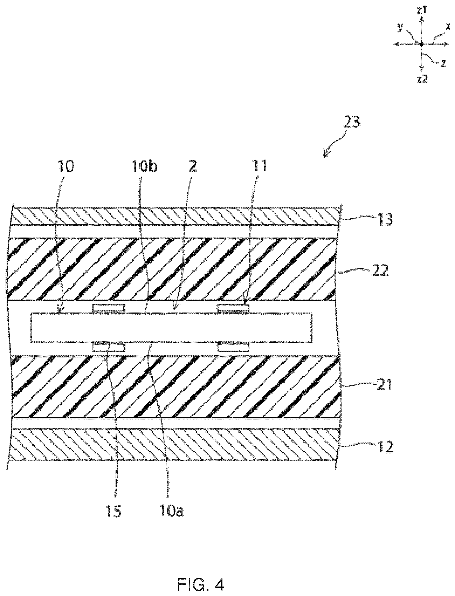

The following is an explanation of an example of a manufacturing method for a solar module 1 with reference primarily to FIG. 4.

First, a light-receiving surface protecting member 12, a first resin sheet 21 for constituting a portion of the sealing member 14, a solar cell string 2, a second resin sheet 22, and a back surface protecting member 13 are stacked in this order. This creates a multilayer 23. In the solar module 1, the entire sealing member 14 comprises resin portions containing a non-crosslinked resin. For this reason, both the first and second resin sheets 21 and 22 contain a non-crosslinked resin.

Next, multilayers 23 are laminated to create a sealing member 14 from first and second resin sheets 21 and 22 (lamination process). This completes the solar module 1.

In the present embodiment, the multilayers 23 are laminated at a temperature lower than the glass transition temperature of the resin adhesive 15. For this reason, during the lamination process, the resin adhesive 15 becomes vitreous but the creep fracture phenomenon does not occur and the adhesiveness of the resin adhesive 15 is maintained. Therefore, displacement of the wiring member 11 during the lamination process can be controlled. As a result, the positional accuracy of the wiring member 11 is high, and highly reliable solar modules 1 can be obtained using a high-yield solar module manufacturing method.

In order to more effectively control the displacement of the wiring member 11 during the lamination process, the multilayers 23 are laminated at a temperature lower than the glass transition temperature of the resin adhesive 15 by at least 20°C.

The following is an explanation of another example of a preferred embodiment of the present invention. In the following explanation, all members having functions substantially identical to those in the first embodiment are denoted by the same reference symbols and further explanation of these members has been omitted.

### 2nd Embodiment

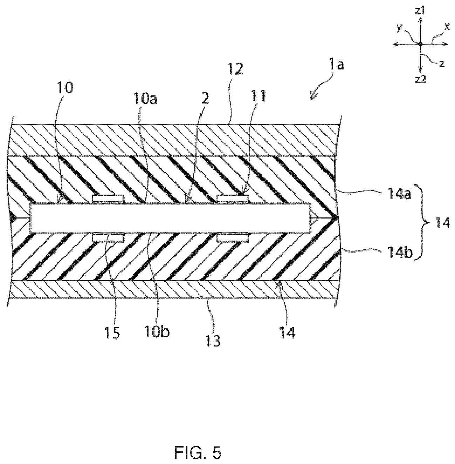

FIG. 5 is a schematic cross-sectional view along the x-direction and the z-direction of a solar module 1a according to a second embodiment.

The first embodiment contained an explanation of an example in which the entire sealing member 14 comprises resin portions containing a non-crosslinked resin.

In the solar module 1a, the sealing member 14 includes a first sealing member portion 14a which comes into contact with the light-receiving surface 10a of a solar cell 10, and a second sealing member portion 14b which comes into contact with the back surface 10b of the solar cell 10. The second sealing member 14b contains a non-crosslinked resin, but the first sealing member 14a contains a crosslinked resin such as ethylene-vinylacetate (EVA) containing a crosslinking agent.

In the solar module 1a, the glass transition temperature of the resin adhesive 15 is higher than the melting point of the second sealing member 14b. For this reason, if the temperature of the solar module 1a rises, the second sealing member 14b melts, and the wiring member 11 is subjected to stress due to the thermal expansion coefficient. Even so, positional displacement of the wiring member 11 can be controlled in the portion bonded to the back surface 10b.

Displacement of the portion of the wiring member on the side with light-receiving surface protecting member is unlikely to occur because thermal expansion of the sealing member portion is restricted by the light-receiving surface protecting member, which comprises a rigid substrate. Displacement of the portion of the wiring member on the side with the back surface protecting member is more likely to occur because thermal expansion of the sealing member portion is not effectively restricted by the back surface protecting member, which comprises a flexible sheet. Therefore, when only one of the first and second sealing material portions includes a non-crosslinked resin, as in the present embodiment, the one containing the crosslinked resin is preferably the second sealing member portion positioned on the side with the back surface protecting member, which comprises a flexible sheet.

The solar module 1a can be manufactured using substantially the same method as explained in the first embodiment. The only difference is that the first resin sheet 21 is a resin sheet containing a crosslinked resin, and the second resin sheet 22 is a resin sheet containing a non-crosslinked resin. During the manufacture of solar module 1a, as in the case of the manufacture of solar module 1, the temperature at which the multilayers 23 are laminated is lower than the glass transition temperature of the resin adhesive 15, preferably lower than the glass transition temperature of the resin adhesive 15 by at least 10°C. In this way, positional displacement of the wiring member 11 can be controlled in the portion bonded to the back surface 10b.

In the present invention, there are no particular restrictions on the sealing member as long as the portion in contact with the wiring member on at least one main surface of the solar cells contains a non-crosslinked resin.

The present invention includes many embodiments not described herein. In the manufacturing method for a solar module according to the present invention, the entire sealing member may contain a non-crosslinked resin.

The sealing member may also consist of three or more sealing member portions.

The present invention will now be explained in greater detail with reference to specific test examples. The present invention is not limited to the following test examples in any way. Modifications are possible without altering the spirit of the present invention.

### Examples

In the test examples, polyethylene (PE) with a melting point of 120°C was used as the non-crosslinked sealing member 14 in the creation of solar modules having a configuration substantially identical to that of the solar module 1 according to the embodiment described above. As shown in Table 1, the glass transition temperature of the resin adhesive 15 (as measured using the TMA method) was in a range from 120°C to 150°C.

Table 1 shows the sealing members 14 used in the test examples and their melting points, the temperatures of the sealing members 14 during lamination, the glass transition temperatures of the resin adhesives 15, the incidence of displacement of the wiring member 11 from the solar cell 10 after lamination, and the incidence of displacement of the wiring member 11 from the solar cell 10 outdoors.

**Table 1**

| Sealing Member 14/ Melting Point | Temperature of Sealing Member 14 During Lamination | Glass Transition Temperature of Resin Adhesive 15 | Incidence of displacement of wiring member 11 from solar cell 10 after lamination | Incidence of displacement of wiring member 11 from solar cell 10 outdoors |
|---|---|---|---|---|
| PE/120°C | 130°C | 120°C | 20% | 30% |
| PE/120°C | 130°C | 130°C | 5% | 20% |
| PE/120°C | 130°C | 140°C | 0% | 5% |
| PE/120°C | 130°C | 150°C | 0% | 0% |

The incidence of displacement of wiring members 11 from solar cells 10 after lamination in Table 1 was calculated by counting the number of solar modules, out of a total of 50 solar modules, in which a wiring member 11 became displaced from a solar cell 10 by a predetermined amount after lamination.

In the test examples, the lamination was performed at a thermo-compression bonding temperature of 150°C, and at an evacuation time and bonding time of ten minutes each. During the evacuation time and bonding time, air bubbles are eliminated from the solar module 1 after lamination. As a result, the temperature of the sealing member 14 was 130°C in the test examples.

The incidence of displacement of wiring members 11 from solar cells 10 was determined in indoor testing described below.

### Details of Indoor Test

A 50 mm² heater was placed in the central portion of the back surface protecting member 13 to heat the sealing member 14 in contact with the back surface protecting member 13 to a temperature of 140°C. After being held at this temperature for 30 minutes, the portion was cooled to room temperature (25°C) to complete a single cycle. After ten of these cycles, the incidence of displacement of wiring members 11 from solar cells 10 was determined.

It was clear from the results of the test examples that displacement of wiring members 11 during the lamination process could be controlled by performing lamination when the glass transition temperature of the sealing member (lamination temperature) is at or below the glass transition temperature of the resin adhesive 15.

It was also found that a resin adhesive 15 with a glass transition temperature greater than the melting point of the sealing member 14 could more effectively control displacement of wiring members and produce a highly reliable solar module even when the temperature of the sealing member 14 was above the melting point of the sealing member 14.

A glass transition temperature 15 of 150°C or greater has been found to be especially preferred for the resin adhesive 15 used to connect solar cells 10 and wiring members 11.

### Key to the Drawings

- 1, 1a:: Solar module
- 2:: Solar cell string
- 10:: Solar cell
- 10a:: Light-receiving surface
- 10b:: Back surface
- 11:: Wiring member
- 12:: Light-receiving surface protecting member
- 13:: Back surface protecting member
- 14:: Sealing member
- 14a:: First sealing member portion
- 14b:: Second sealing member portion
- 15:: Resin adhesive
- 21:: First resin sheet
- 22:: Second resin sheet
- 23:: Multilayer

## Claims

1. A manufacturing method for a solar module (1) having a sealing member (14) and a solar cell string (2) arranged inside the sealing member (14), the solar cell string (2) having a plurality of solar cells (10), a wiring member (11) connecting the plurality of solar cells (10) electrically, and a resin adhesive (15) bonding the wiring member (11) and the plurality of solar cells (10), the manufacturing method comprising the steps of:
stacking a first resin sheet (21) for constituting a portion of the sealing member (14), the solar cell string (2), and a second resin sheet (22) for constituting another portion of the sealing member (14) in this order to create a multilayer (23), wherein at least one of the first and second resin sheets (21, 22) contains a non-crosslinked resin; and
laminating the multilayer (23) to configure the sealing member (14) from the first and second resin sheets (21, 22) and obtain a solar module (1);
**characterized by** the lamination of the multilayer (23) being performed at a temperature less than the glass transition temperature of the resin adhesive (15) by at least 20°C, and
the melting point of the sealing member (14) being from 60°C to 180°C.

2. The manufacturing method for a solar module according to claim 1, wherein the glass transition temperature of the resin adhesive (15) is equal to or higher than 140°C.

## Patentansprüche

1. Herstellungsverfahren für ein Solarmodul (1) mit einem Dichtungselement (14) und einem Solarzellen-Strang (2), der innerhalb des Dichtungselements (14) angeordnet ist, wobei der Solarzellen-Strang (2) eine Anzahl von Solarzellen (10) aufweist, ein Verdrahtungselement (11), das die Anzahl von Solarzellen (10) elektrisch verbindet, und ein Harz-Klebemittel (15), das das Verdrahtungselement (11) und die Anzahl von Solarzellen (10) verbindet, wobei das Herstellungsverfahren die Schritte aufweist:
Stapeln einer ersten Harzschicht (21) zur Bildung eines Teils des Dichtungselements (14), des Solarzellen-Strangs (2) und einer zweiten Harzschicht (22) zur Bildung eines weiteren Teils des Dichtungselements (14) in dieser Reihenfolge, um eine mehrschichtige Struktur (23) zu bilden, wobei mindestens eine der ersten und der zweiten Harzschicht (21, 22) ein nicht vernetztes Harz enthält, und
Laminieren der mehrschichtigen Struktur (23) zur Bildung des Dichtungselements (14) von der ersten und der zweiten Harzschicht (21, 22) und zum Erhalt eines Solarmoduls (1), **dadurch gekennzeichnet, dass** das Laminieren der mehrschichtigen Struktur (23) bei einer Temperatur von weniger als mindestens 20 °C der Glas-Übergangstemperatur des Harz-Klebemittels (15) durchgeführt wird und
der Schmelzpunkt des Dichtungselements (14) von 60 °C bis 180 °C beträgt.

2. Herstellungsverfahren für ein Solarmoduls nach Anspruch 1, wobei die Glas-Übergangstemperatur des Harz-Klebemittels (15) gleich oder größer als 140 °C ist.

## Revendications

1. Procédé de fabrication d'un module solaire (1) ayant un élément d'étanchéité (14) et une chaîne de cellules solaires (2) agencée à l'intérieur de l'élément d'étanchéité (14), la chaîne de cellules solaires (2) ayant une pluralité de cellules solaires (10), un élément de câblage (11) connectant électriquement la pluralité de cellules solaires (10), et un adhésif de résine (15) liant l'élément de câblage (11) et la pluralité de cellules solaires (10), le procédé de fabrication comprenant les étapes suivantes :
empiler une première feuille de résine (21) pour constituer une partie de l'élément d'étanchéité (14), la chaîne de cellules solaires (2), et une deuxième feuille de résine (22) pour constituer une autre partie de l'élément d'étanchéité (14) dans cet ordre, pour créer une multicouche (23), dans lequel au moins l'une des première et deuxième feuilles de résine (21, 22) contient une résine non réticulée ; et
stratifier la multicouche (23) pour configurer l'élément d'étanchéité (14) à partir des première et deuxième feuilles de résine (21, 22) et obtenir un module solaire (1) ;
**caractérisé en ce que** la stratification de la multicouche (23) est réalisée à une température inférieure à la température de transition vitreuse de l'adhésif de résine (15) par au moins 20 °C, et
le point de fusion de l'élément d'étanchéité (14) est de 60°à 180 °C.

2. Procédé de fabrication d'un module solaire selon la revendication 1, dans lequel la température de transition vitreuse de l'adhésif de résine (15) est égale ou supérieure à 140 °C.
